# EUROPEAN PATENT SPECIFICATION

(11) **EP 1 158 676 B1**
(45) Date of publication and mention of the grant of the patent: **22.03.2006**
(21) Application number: 01304545.5
(22) Date of filing: 23.05.2001
(51) Int. Cl.: H03J 7/00, H04B 1/12

(54) **Interference reducing circuit and television broadcasting receiver**
Schaltungsanordnung zur Reduzierung von Störungen und Fersehempfänger
Circuit pour la réduction d'interférences et récepteur de télévision

(30) Priority: 25.05.2000 JP 2000159580
(43) Date of publication of application: 28.11.2001
(73) Proprietor: SONY CORPORATION, Tokyo 141-0001 (JP)
(72) Inventor: Takeuchi, Isao, c/o Sony Corporation, Shinagawa-ku, Tokyo (JP)
(74) Representative: Nicholls, Michael John

(56) References cited:
- DE-A- 4 220 296
- US-A- 4 027 264
- US-A- 4 859 958
- US-A- 5 488 632
- US-A- 5 826 181

## Description

The present invention relates to an interference reducing circuit for reducing an interference wave that is mixed in a reception wave. In particular, the invention relates to a TV broadcasting receiver that is equipped with an interference reducing device that effectively reduces an interference wave or the like that will act as a disturbance wave to a broadcast signal received by a digital broadcasting receiver and that is suitable for use in a receiving apparatus.

As opposed to conventional analog transmission type TV broadcasts, digital multi-channel broadcasts using a satellite have already been realized though they are commercial ones. To effectively utilize the transmission bands, it is desired that digital versions (hereinafter referred to as "digital broadcasts") of ground-wave broadcasts be realized and spread.

However, conventional ground-wave analog broadcasts (hereinafter referred to as "analog broadcasts") will not be switched to digital broadcasts all at once and the two kinds of broadcasting will coexist in the initial stage of the transition. For example, since it is planned to send digital broadcasts using part of the current UHF broadcasting channels, unused channels of each area can be used for digital TV broadcasts or digital radio broadcasts.

The OFDM (orthogonal frequency division multiplexing) scheme in which data is transmitted being distributed to many carriers is employed for transmission of a broadcast wave of a digital TV broadcast. The OFDM is a transmission scheme in which ghosts do not tend to occur because signal processing can be performed so that one data symbol lasts for a long time.

Being a modulation scheme in which ghosts do not tend to occur, the OFDM has an advantage that it can be used for an SFN (single frequency network) in which relay broadcasting stations that relay the same program can use the same transmiss ion frequency. Further, even if a particular carrier is affected by selective fading, only part of data is lost and error correction is enabled.

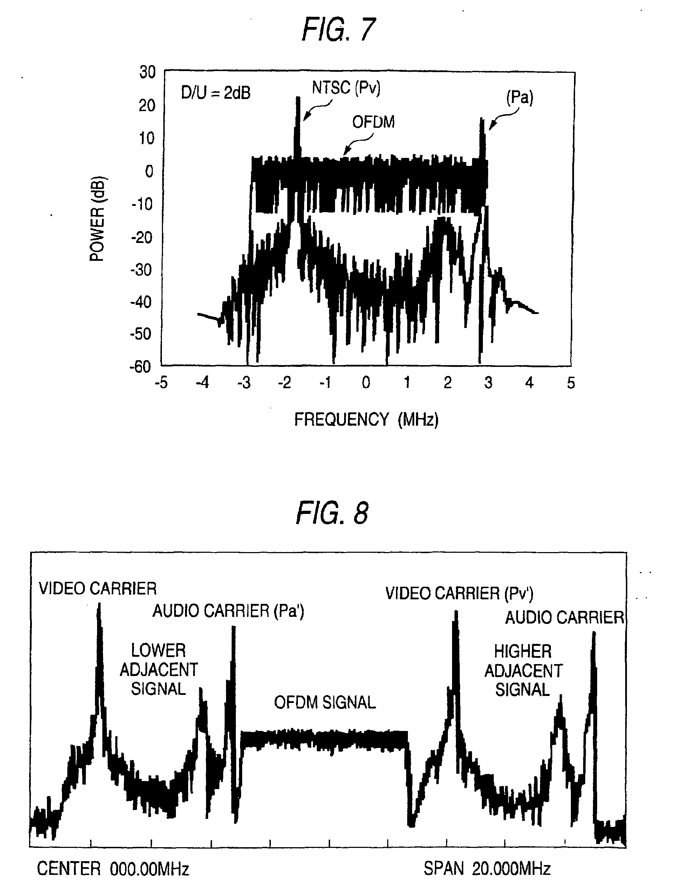

In the NTSC broadcasting area, a plan is such that the broadcasting bandwidth of each broadcasting channel will be made 6 MHz as in the case of the analog broadcasting. In the OFDM scheme, since digitized video/audio information is sent simultaneously by using thousands of carrier waves, sending power that is modulated by a digital signal and then output is distributed to many, approximately uniform spectral components in a certain broadcasting channel (6 MHz) as indicated by "OFDM" in Fig. 7. In contrast, like a spectrum shown in the lower part of Fig. 7, the power of an analog broadcast in the same channel is such that a video carrier Pv that is amplitude-modulated according to video information and an audio subcarrier Pa that is frequency-modulated according to an audio signal give peak levels and broadcast power spectral components are distributed around the carriers Pv and Pa. In particular, the peak levels of the carriers Pv and Pa are prominent.

Therefore, when in the future a channel in the UHF band is assigned to a digital broadcast, if the same channel close to it is used for an analog broadcast, the video carrier Pv and the audio subcarrier Pa of the analog broadcast may act as strong interference waves to the digital broadcast as seen from Fig. 7. Even if the same channel is not used for an analog broadcast, there is fear that particularly the audio subcarrier component Pa' of an adjacent analog broadcast channel will leak into the digital broadcast channel due to a multi-path or fading phenomenon and cause interference as shown in Fig. 8 depending on the frequency selection characteristic of a high-frequency circuit. Depending on the IF characteristic of a receiver, the interference wave component may be demodulated as digital data to increase the error rate of demodulated data and cause picture disappearance or image quality deterioration. For a similar reason, the video carrier Pv' of a channel that is adjacent to and higher than the reception channel may act as an interference wave.

In view of the above, it was proposed to reduce interference by inserting a comb filter, a notch filter, or the like that is designed in consideration of an interference wave in an RF circuit of a receiving section, to thereby cancel a carrier component of another station that will act as an interference wave to a digital broadcasting channel (Japanese Patent Application No. Hei. 10-11018). However, since general band-pass filters have a comb-shaped attenuation characteristic, the reduction of an interference wave in the same channel causes reduction of digital data. For this reason, this measure cannot increase the error correction rate of demodulated data to a large extent. In particular, it is difficult to eliminate a lower adjacent audio signal of a channel adjacent to the reception channel. There is a problem that to attain, by means of a filter or the like, reduction at an interference frequency where an interference wave may occur, interference waves cannot be reduced in a stable manner because the reduction frequency shifts from the target frequency due to a drift of a local frequency of a receiver.

US 5,826,181 discloses a noise reduction circuit for reducing noise in an analog radio signal. The circuit consists of a phase-locked loop circuit which is locked to the frequency of a noise signal, a phase inverter for inverting the output of the phase-locked loop circuit, a variable gain amplifier that adaptively amplifies the output of the phase inverter and signal combiner that combines the output of the variable gain amplifier with the original signal.

According to the invention, there is provided an interference reducing circuit for a television receiver receiving means for receiving a desired digital television broadcasting of OFDM modulation wave of a selected channel, together with an interference analog television broadcasting wave signal, and a signal processing circuit for demodulating an output from said receiving means and for converting said output into digital data;
wherein said interference reducing circuit comprises:
phase locking means for generating a signal component phase-locked to said frequency of the interference wave signal that is mixed in the digital data from said signal processing circuit;
level adjustment means for outputting a replica signal of said interference wave signal by adjusting a level of said signal component from the phase locking means; and
subtracting means for subtracting said replica signal obtained by the level adjusting means from the digital data of said signal processing circuit.

The reception wave from which the interference wave signal component is eliminated is output from the subtracting means.

Optionally, the phase locking means comprises a voltage-controlled oscillator for producing a signal having a frequency that is varied by voltage control; phase comparing means for comparing phases of an output of the voltage-controlled oscillator and the interference wave; and a feedback circuit for feeding back, as a control voltage for the voltage-controlled oscillator, via a second-order loop filter, a phase error signal that is produced by the phase comparing means.

Optionally, the level adjusting means comprises a first-order loop filter and adjusts a level of the interference wave based on a level of a signal produced by the phase locking means.

Optionally, the interference wave is an amplitude-modulated or frequency-modulated carrier, and wherein a loop characteristic of the phase locking means is so set as to follow an amplitude modulation component or a frequency modulation component. This makes it possible to reduce an interference wave signal even if it is an AM or FM carrier.

According to a further aspect of the invention, there is provided a TV receiver comprising:
receiving means for receiving a desired digital television broadcasting of OFDM modulation wave of a selected channel together with an interference analog television broadcasting wave signal;
a signal processing circuit for demodulating an output from said receiving means and for converting said output into digital data;
and an interference reducing circuit as specified above.

Optionally, the phase locking means attains locking to an interference wave frequency signal that is video carrier information or audio subcarrier information of another analog TV reception wave that is set in the same channel as the broadcast.

Optionally, the phase locking means comprises a sinusoidal information signal generating section for producing a signal having a phase that is varied in accordance with control information; phase comparing means for comparing phases of an output of the sinusoidal information signal generating section and the interference wave; and a feedback circuit for feeding back, as a control voltage for the sinusoidal information signal generating section, via a second-order loop filter, a phase error signal that is produced by the phase comparing means.

Optionally, the level adjusting means comprises a first-order loop filter and adjusts the level of the interference wave based on a level of a signal produced by the subtracting means.

The hereinafter described embodiments of the invention can enable reduction of an interference wave by providing a phase locking means for attaining phase locking to a wave that will interfere with a receiver and a level adjusting means capable of adjusting the level of a phase-locked signal produced by the phase locking means, generating a replica of a main interference wave frequency signal by means of the phase locking means and the level adjusting means, and subtracting the interference wave frequency signal from a reception signal.

Embodiments of the invention will now be described by way of non-limitative example with reference to the accompanying drawings, in which:
Fig. 1 is a basic block diagram of an interference reducing device;
Figs. 2A-2C show how an interference signal is reduced;
Fig. 3 is a block diagram of a TV broadcasting receiver having an interference reducing circuit according to the invention;
Fig. 4 is a block diagram of another TV broadcasting receiver having an interference reducing circuit according to the invention;
Fig. 5 is a block diagram of a phase locking section that is part of an interference reducing circuit;
Fig. 6 is a block diagram of a level adjusting section for adjusting the level of an extracted interference wave signal;
Fig. 7 shows a spectrum of a digital broadcast reception wave and an interference wave signals; and
Fig. 8 shows interference waves that are mixed into a digital broadcast reception wave from an adjacent channel.

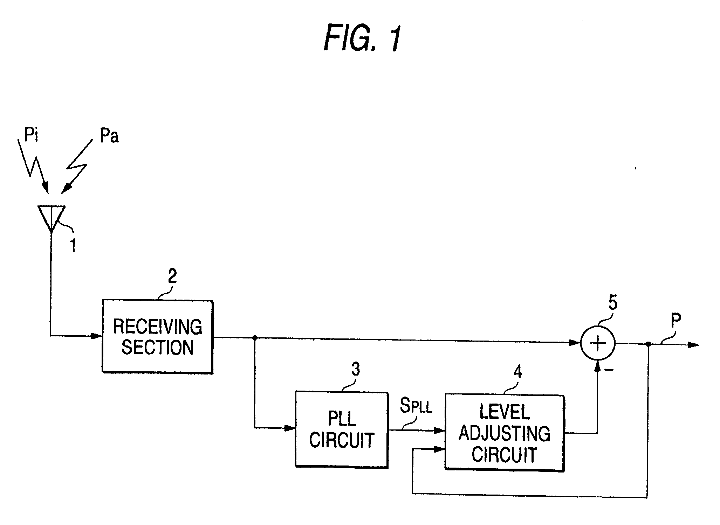

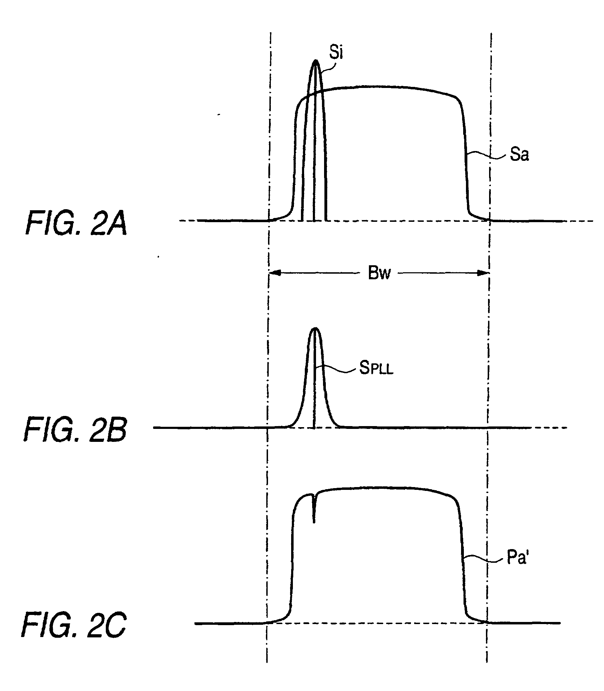

Figs. 1 and 2A-2C outline an interference reducing device of a receiver according to the present invention.

In Fig. 1, reference numeral 1 denotes an antenna for receiving radio waves Pa and numeral 2 denotes a receiving section for tuning in to a desired channel of the received radio waves Pa. It is assumed that the antenna 1 simultaneously receives a radio wave Pi that will act as a disturbance wave and the receiving section 2 performs first demodulation on it. Reference numeral 3 denotes a phase locking circuit provided on the output side of the receiving section 2. For example, the phase locking circuit 2 is a PLL circuit that attains phase locking particularly at the frequency of an interference wave among input signals.

Reference numeral 4 denotes a level adjusting circuit for adjusting the signal level of a phase-locked signal that is output from the phase locking circuit 3. An adjusted signal that is output from the level adjusting circuit 4 is supplied to a subtracter 5 as a replica of an interference wave signal.

The subtracter 5 is also supplied with a reception signal that is received by the receiving section 2. The subtracter 5 eliminates that component of the reception signal which has the frequency of the replica of the interference wave signal.

The reception signal from which the component having the frequency of the replica of the interference wave signal is eliminated is fed back to the level adjusting circuit 4, whereby the level of the replica of the interference wave signal is adjusted.

How an interference wave is reduced will be described below by using signal spectra (envelopes) of reception radio waves shown in Figs. 2A-2C. It is assumed that as shown in Fig. 2A a spectrum Si of a radio wave that will act as an interference wave having a very high peak level is mixed in a frequency spectrum Sa (bandwidth: BW) of a channel that is received by the antenna 1 and selected by the receiving section 2.

Usually, the PLL circuit as the phase locking circuit 3 has a locking range and a capturing range having prescribed values . Therefore, if the PLL circuit is so configured that its vicinity of the frequency of the spectrum Si of a radio wave that will act as an interference wave is included in the locking range and the other frequency portions are out of the capturing range, as shown in Fig. 2B the PLL circuit attains phase locking at the frequency of the interference wave spectrum having the highest level in the locking range and produces a PLL output signal S_{PLL}.

The PLL output signal S_{PLL} is supplied to the level adjusting circuit 4, which performs control so that the level of the PLL output signal S_{PLL} becomes equal to the signal level of the interference wave frequency spectrum Si of the spectrum of the received radio waves. Therefore, the level adjusting circuit 4 outputs a signal that is a replica of the interference wave signal that is mixed in the reception signal in the selection range of the receiving section 2. By subtracting the replica of the interference wave signal from the output signal of the receiving section 2, a signal having a spectrum envelope Pa' shown in Fig. 2C is obtained in which the interference wave spectrum Si having different information than information in the reception channel is eliminated.

If a signal that will act as an interference wave is modulated according to information, the spectrum Si of the signal has a prescribed bandwidth with its frequency or amplitude varied. The device can follow a frequency variation of an interference wave by properly setting the loop time constant of the PLL circuit and can also follow an amplitude variation by properly setting the control loop time constant of the level adjusting circuit 4.

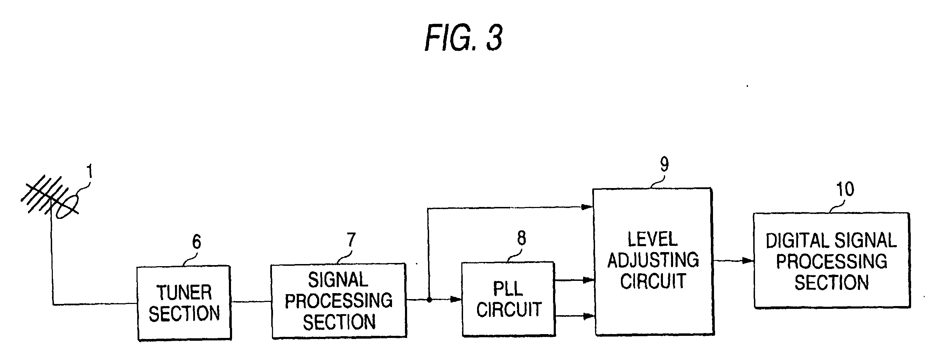

Fig. 3 is a block diagram showing an embodiment in which the above-described interference reducing circuit is applied to a TV broadcasting receiver. In Fig. 3, reference numeral 1 denotes an antenna for receiving digital broadcasts. Reference numeral 6 denotes a tuner section for tuning in to a desired channel. Reference numeral 7 denotes a digital signal processing section for demodulating an output of the tuner section 6 into digital data through conversion into an IF frequency and decoding it into a broadcasting-station-side database signal through various kinds of signal conversion.

A digital signal that is output from the digital signal processing section 7 is supplied to a phase locking circuit 8 and a level adjusting circuit 9 that constitute an interference reducing circuit according to the invention. Information included in an interferencewave signal is detected by the circuits 8 and 9 and supplied to a digital signal processing circuit 10.

The phase locking circuit 8 is a PLL (hereinafter referred to as DPLL) circuit that is a digital circuit. The phase locking circuit 8 may be a digital signal processing type PLL circuit using various digital operation elements that perform operations on digital data itself without converting it into a digital signal waveform.

As the digital signal processing circuit 10, a DSP (digital signal processor) that performs various kinds of digital signal processing is used in accordance with the contents of a modulation wave. For example, where transmission data is formed by video information, a signal that is coded according to the MPEG2 is input to a dedicated DSP that produces time-axis video data by performing DCT (discrete cosine transform) and motion compensation inter-frame predictive decoding, forms frame image data, and expands compressed video information.

Where transmission data is audio information, different kinds of signal processing are performed depending on whether the information is of a monaural broadcast or a stereo broadcast. In the case of a multi-channel broadcast wave obtained by modulating stereo signals or digital data according to a special modulation method, compressed data is also converted into the original audio information by a dedicated DSP. Such digital signal processing is already employed commonly in receivers for receiving satellite broadcast waves, and hence it is not described here in detail.

Operating in the same manner as the phase locking circuit 3 and the level adjusting circuit 4 shown in Fig. 1, the phase locking circuit 8 and the level adjusting circuit 9 that is a digital circuit cancel data information that is mixed as an interference wave in digital information data obtained by demodulating a reception signal.

The receiver as shown in Fig. 3 operates properly in receiving a desired signal according to the OFDM scheme. There is possibility that in the future such a receiver will be used for reception of radio broadcasts and FM broadcasts. In such a case, various kinds of information as data are superimposed on audio information and received. In digital receivers, the error correction rate of data decreases if a carrier of another broadcast frequency that will act as a disturbance wave is mixed in a desired reception channel. However, in the case of the embodiment of the invention, since the above-described interference reducing device for processing reception information that is converted into a digital signal is added in the form of the phase locking circuit 8 and the level adjusting circuit 9, the SNR can be increased.

As described above, the phase locking circuit 8 generates a signal component that is phase-locked to an interference wave in a reception channel. This signal component is supplied to the level adjusting circuit 9 that performs control so that the level of the signal component becomes equal to the level of the signal that is received as the interference wave. A replica of the interference wave signal that is output from the level adjusting circuit 9 is used in the digital signal processing circuit 10 to eliminate the interference wave from demodulation data.

The DPLL circuit as the phase locking circuit 8 prohibits the interference wave compensation operation if the level and the frequency of an input signal are not within certain ranges, that is, if the level of a signal that will act as an interference wave is equivalent to or smaller than the signal level of a desired wave. That is, the interference reducing circuit is so configured as to output an interference signal component particularly when the desired reception wave is a digitally modulated signal and a signal that will act as an interference wave is received as an analog signal obtained by modulating a single carrier and having a level that is higher than or equal to a certain level.

Where the frequency of an interference wave is known in advance, by setting the fundamental frequency of the DPLL circuit as the phase locking circuit 8 in the vicinity of the interference wave frequency and making the locking range narrow, the interference reducing circuit can be applied to a receiver that receives transmission radio waves according to any of various schemes obtained by digitally modulating a single carrier according to a multi-value signal rather than OFDM radio waves.

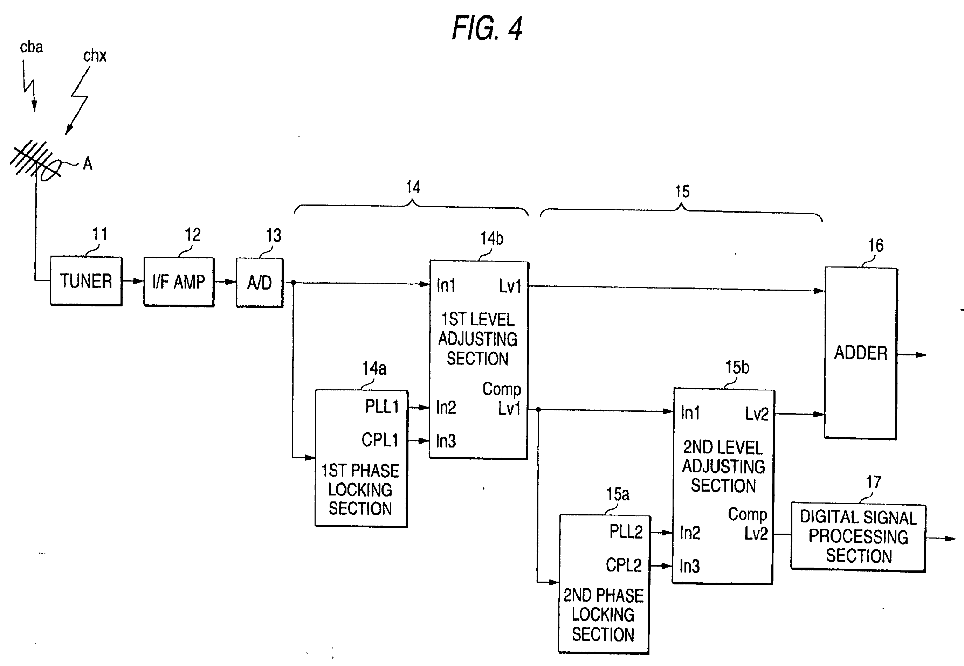

Fig. 4 shows an embodiment in which the interference reducing circuit according to the invention is applied to a digital TV receiver. In Fig. 4, reference character A denotes an antenna for receiving a digital broadcast, numeral 11 denotes a front tuner, and numeral 12 denotes an amplifier for amplifying an IF signal. The amplifier 12 may be omitted depending on the front tuner 11. Reference numeral 13 denotes anA/D conversion section for converting an IF signal into a digital signal. The sampling frequency of the A/D conversion section 13 is so set as to allow the A/D conversion section 13 to output a quantized signal (e.g., complex data) that is digital data of 10 bits, for example, generated by using a clock signal that satisfies at least the Nyquist condition. Ideally, it is preferable that the sampling frequency be two or more times the IF frequency. However, for interference reduction, the sampling may be performed at a sampling period tₛₐₘ (= 0.5) that is approximately a half of the signal rate period t_{sym} (= 1) of a reception signal.

Reference numeral 14 denotes a first interference reducing circuit section for detecting, as an interference wave, a video carrier of another analog TV channel signal that is mixed in a selected channel. The first interference reducing circuit section 14 consists of a phase locking section 14a and a level adjusting section 14b as described above. Reference numeral 15 denotes a second interference reducing circuit section for eliminating, as an interference wave, an audio subcarrier of another analog TV channel signal that is mixed in a reception channel. The second interference reducing circuit section 15 likewise consists of a second phase locking section 15a and a level adjusting section 15b.

The first phase locking section 14a is a DPLL circuit that captures reception digital data that is output from the A/D conversion section 13 and outputs a signal that is synchronized with a video carrier that will act as an interference wave. The first phase locking section 14a outputs a synchronized signal PLL1 and its conjugate signal CPL1. The first level adjusting section 14b receives, as inputs In2 and In3, the outputs PLL1 and CPL1 of the first phase locking section 14a, and produces an output Lv1 that is digital data obtained by adjusting, based on reception digital data as an input In1, a phase-locked interference wave signal so that its level becomes equal to a level corresponding to a reception video carrier signal as well as an output CompLv1 that is digital data obtained by eliminating data of the interference wave from the reception data.

Therefore, the first level adjusting section 14b produces, as the output Lv1, a replica of the carrier component of the analog video signal that is mixed in the same channel and also produces, as the output CompLv1 of the first level adjusting circuit, a signal in which the interference wave component whose replica is output as the output Lv1 is eliminated. The output CompLv1 is input to the second phase locking section 15a that is the DPLL circuit and the second level adjusting section 15b.

The second phase locking section 15a, which is configured in the same manner as the first phase locking section 14a, is so set as to attain phase locking to an audio subcarrier that ismixedasaninterferencewave. The second phase locking section 15a supplies the second level adjusting section 15b with outputs PLL2 and CPL2 that are digital data of the audio subcarrier to which phase locking is made as an interference wave. The output CPL2 is a conjugate signal of the output PLL2. The second level adjusting section 15b receives, as inputs In2 and In3, the outputs PLL2 and CPL2 of the second phase locking section 15a, and produces an output Lv2 that is digital data obtained by adjusting, based on the output CompLv1 as an input In1, a phase-locked interference wave signal so that its level becomes equal to a level corresponding to a reception audio subcarrier signal as well as an output CompLv2 that is digital data obtained by eliminating data of the interference wave from the reception data.

The level-adjusted output Lv2 of the second level adjusting section 15b is added to the output Lv1 of the first level adjusting section 14b by an adder (subtracter) 16, whereby a replica signal of the interference wave resulting from the analog TV signal that is mixed in the reception channel is output.

A signal obtained by eliminating the replica signal of the interference wave from the reception digital TV information, that is, the digital data CompLv2 of the reception wave that has been compensated for the interference component, is output from the second level adjusting section 15b and supplied to a digital signal processing section 17 as in the above-described case. In the digital signal processing section 17, video information and audio information are restored by decoding. The video information is subjected to various kinds of digital decoding processing and a component video signal is finally supplied to a display means.

For example, where transmission data is formed by video information, a spectrum of each carrier is obtained through Fourier transform and data of each carrier is P/S-converted into demodulation data. Since the demodulation data is such that the video information is compressed according to the MPEG2, for example, the demodulation data is input to a DSP that is dedicated to expansion of such data. The audio information is separated from the video information. Data of separated digital audio information is decoded into original digital audio data, based on which an analog audio signal is formed. In this manner, the digital signal processing section 17 restores video component data and audio data through decoding and outputs a composite video signal and an audio signal to a TV receiver in the same manner as in set-top boxes for digital television that are already put to practical use.

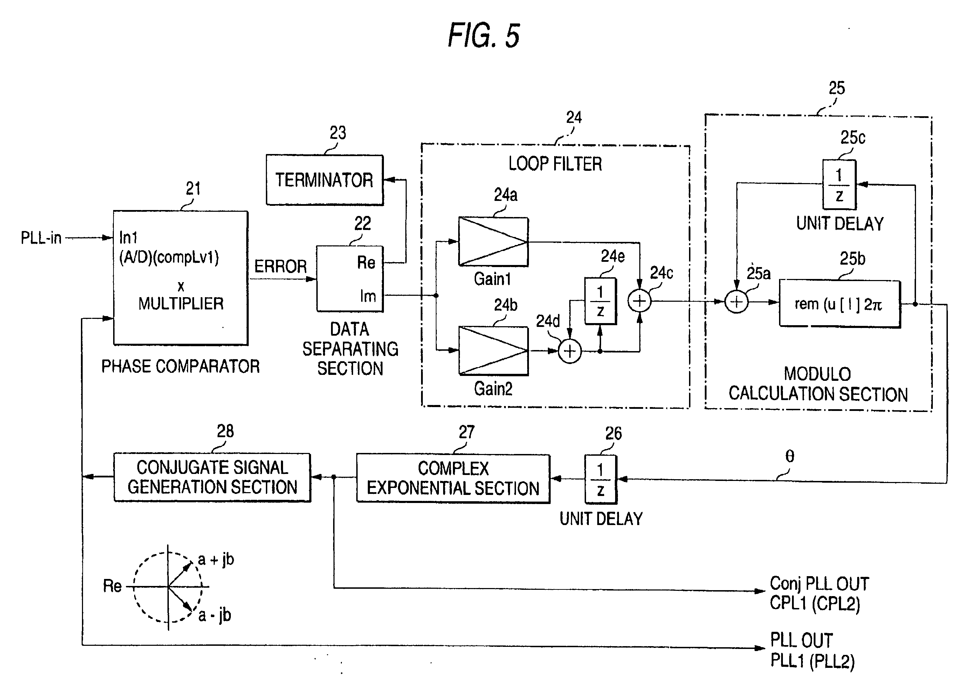

Fig. 5 is a block diagram showing a specific example of the first phase locking section 14a or the second phase locking section 15a that is used in the TV receiver of Fig. 4. The pull-in operations performed by the first phase locking section 14a and the second phase locking section 15a are essentially the same, though they are different from each other in detail depending on whether the interference wave to which the DPLL circuit attains locking is a video carrier or an audio subcarrier.

In Fig. 5, reference numeral 21 denotes a multiplier for detecting a phase difference between a reception digital TV signal In1 in which an interference wave signal component is included and a signal PLLout that is locked to an interference wave signal by the DPLL circuit. Reference numeral 22 denotes a data separating section for separating from each other a real component and an imaginary component of phase data that is detected by the multiplication. The separated real component Re is absorbed by a terminator 23.

The imaginary component Im separated by the data separating section 22 is supplied to a second-order loop filter 24, which has two amplifiers 24a and 24b. The gains of the first amplifier 24a and the second amplifier 24b are set at 2·Damp·ωₙ₁ and ωₙ₁·ωₙ₁, respectively, where Damp is a damping factor (usually, 0.7) of the second-order PLL, circuit and ωₙ₁ is a natural angular frequency of the second-orderPLL circuit. An output of the second amplifier 24b is integrated by an integration circuit that consists of an adder 24d and a one-clock delay section 24e.

An output of the loop filter 24 is supplied to a modulo calculation section 25 having a period of 2π. Consisting of an adder 25a, a calculation section 25b for calculating rem (u[1]2π), and a unit delay section 25c, the modulo calculation section 25 converts input phase data into phase data (upper limit value: 2π). (For example, 2nπ + θ = θ where n is an integer.) The phase data θ is delayed by one clock by the unit delay section 26 and then supplied to a complex exponential section (hereinafter referred to as "sinusoidal information data generation section) 27 for producing data that indicates the amplitude and the phase of the signal in the form of a complex number (e^{jθ}). The sinusoidal information data generation section 27 converts the input phase data θ into data that is a complex number r·e^{jθ} = r(cos θ + j sin θ) on the unit circle (r = 1). The sinusoidal information data generation section 27 supplies the resulting data to a conjugate signal generation section 28 for producing conjugate data r(cos θ - j sin θ). An output of the conjugate signal generation section 28 is supplied to the multiplier 21 (phase comparator) as the other input signal.

In general, a clock signal of the downstream digital signal processing section can be used as a clock signal for the calculation in the phase locking section of Fig. 5. It is preferable that the clock signal of the phase locking section be synchronized with a sampling signal to be used for converting a reception IF signal into a digital signal. For example, the period of the master clock signal of the DPLL circuit is the same as the sampling period of FFT (fast Fourier transform) on a desired wave digital signal obtained by sampling at a frequency that is two times the IF frequency of a reception signal or by down-sampling. A frequency and a phase can be set by referring to a table. A PLL output is obtained that is locked to the phase of an interference wave signal having a relatively high level that is mixed in the reception digital information. More specifically, in a state that the DPLL circuit is locked to an interference wave signal, the phase data that is output from the multiplier 21 consists of only a real component. Feedback is so performed that this real component becomes 0 next time, whereby control is so made that input complex sampling data that will act as an interference wave component in the reception channel coincides, in phase, with complex data that is output from the conjugate signal generation section 28. Therefore, in the case of the phase locking section 14a, a PLL output signal that is phase-locked to a video carrier that will act as a disturbance wave is output from the conjugate signal generation section 28 as a signal PLLout. A signal that is phase-conjugate to the phase-locked signal is output from the sinusoidal information generation section 27 as a signal ConjPLLout.

The locking range of the DPLL circuit is set in accordance with a transfer characteristic Tr of the second-order loop filter 24 and particularly depends on the total gain of the DPLL circuit. The capturing range can be determined in connection with the total gain of the PLL circuit and the time constant of the loop filter 24. The loop filter 24 is a circuit that is equivalent to a lag/lead filter as commonly used in DPLL circuits. In the case of the DPLL circuit 14a for attaining locking to a video carrier, the response speed of the loop filter 24 is set relatively low. In the case of the DPLL circuit 15a for attaining locking to an audio subcarrier, the response speed of the loop filter 24 is set high to allow it to follow a frequency shift of the audio subcarrier because the audio subcarrier is frequency-modulated. The initial value of the DPLL circuit is set close to the frequency of an interference wave. With the channel center frequency regarded as 0, it is preferable to set the initial frequency at about -1.4652 (Freq) in the case of the phase locking section 14a for attaining locking to a video carrier and at about 1.9 (Freq2) in the case of the phase locking section 15a for attaining locking to an audio subcarrier.

As described above, in the phase locking section according to this embodiment, the DPLL circuit performs locking when the peak level of an analog video signal that is mixed in a digital TV channel is relatively high. On the other hand, in reducing interference in the same channel, the DPLL circuit does not perform locking when digital data corresponding to a disturbance frequency is not mixed in the bandwidth of a reception channel. In this case, it is preferable to output an unlock signal to the digital signal processing section and turn off the interference reducing routine. The phase locking section of Fig. 5 can also be applied to the digital receiver of Fig. 3.

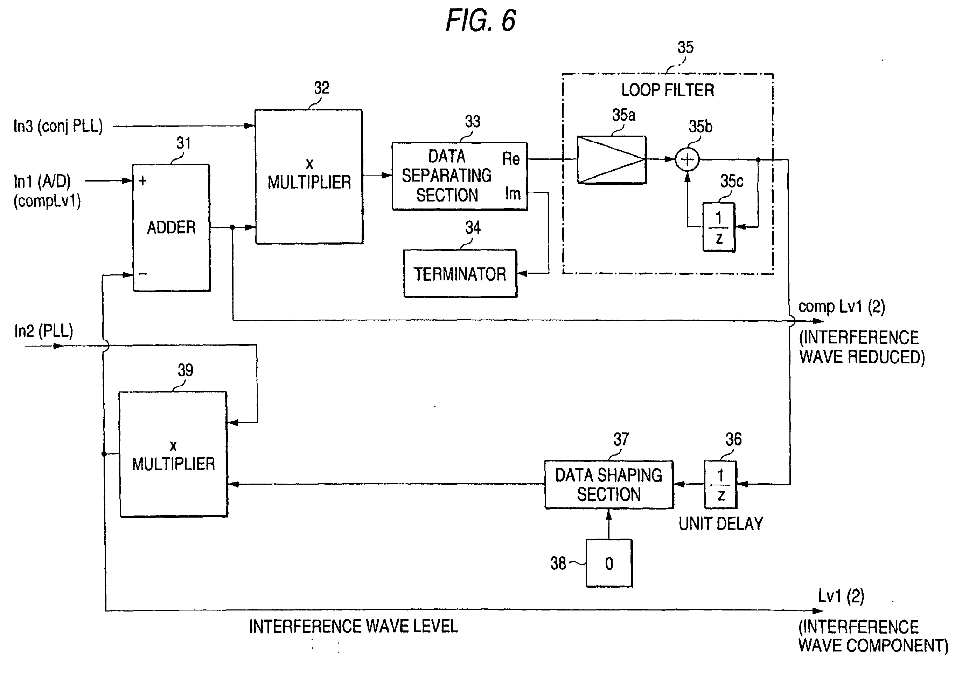

Fig. 6 is a block diagram showing a specific example of the first level adjusting section 14b or the second level adjusting section 15b shown in Fig. 4. The level adjusting actions of the level adjusting sections 14b and 15b are essentially the same. Even when the amplitude of a carrier that will act as an interference wave is varied due to amplitude modulation, fading, or the like, the level adjusting section 14b or 15b detects its variation component and outputs a level-adjusted compensation signal. The level adjusting section 14b, to which a signal that is locked to an analog video carrier that will act as an interference wave is input, compensates for a level variation that is influenced by a video modulation wave signal. The level adjusting section 15b, to which a signal that is locked to an audio subcarrier that will act as an interference wave is input, outputs a compensation signal for compensating for a relatively small level variation particularly due to fading or the like.

As shown in Fig. 6, to serve as the first level adjusting section 14b, the level adjusting section is provided with an adder 31 that receives, as an input In1, a reception digital information signal and also receives an output Lv1 of a level-compensated interference wave signal that is output from the level adjusting section 14b itself, whereby a difference component of the two signals is detected. The level adjusting section is also provided with a multiplier 32 that receives an output of the adder 31 and also receives, as an input In3, an output CPL1 that is locked by the DPLL circuit as the above-described phase locking section 14a, whereby an error signal corresponding to a level difference between the two signals is output.

Reference numeral 33 denotes a data separating section for separating data of a calculation result of the multiplier 32 into a real component and an imaginary component. The separated imaginary component Im is supplied to and absorbed by a terminator 34. The separated real component Re is supplied to a loop filter 35. The loop filter 35, which is a first-order loop filter to which the real component of the output of the multiplier 32 is supplied as an error signal, consists of an amplifier 35a for amplifying a signal at a prescribed gain, an adder 35b for integrating an output of the amplifier 35a, and a unit delay section 35c. The gain of the amplifier 35b is so set as to correspond to the reciprocal (INV TIME) of a time constant τ of the first-order loop filter 35.

An output (discrete data) of the loop filter 35 is delayed by one calculation period by a unit delay section 36 and is given "0" as an imaginary component by a data shaping section 37. The data shaping section 37 is used to provide a complex loop error signal because complex numbers are multiplied by each other in a multiplier 39. The data shaping section 37 may be omitted depending on the configuration of the multiplier 39. Receiving, as the other input In2, complex output data PLL1 or PLL2 that is locked by the above-described DPLL circuit, the multiplier 39 multiplies it by the complex loop error signal. An output of the multiplier 39 is made the other input of the adder 31.

If the level adjusting section 14b or 15b performs numerical calculation using a clock signal that is synchronized with a sampling clock signal that is used in A/D-converting reception digital information, it becomes an AGC circuit that adjusts the output level of the DPLL circuit using the interference wave signal level as a target value. That is, where the level adjusting section is used for eliminating a video carrier as an interference wave, it compensates the level of a replica of the video carrier that is locked by the phase locking section 14a. Where the level adjusting section is used for eliminating an audio subcarrier as an interference wave, it compensates the level of a replica of the audio subcarrier that is locked by the phase locking section 15a. The level adjusting section can be used as either of the level adjusting sections 14b and 15b by changing the response characteristic of the loop filter 35 slightly. For example, the amplifier gain is set at about 0.01 (INV TIME1) for use as the level adjusting section 14b and at about 0.02 (INV TIME2) for use as the level adjusting section 15b.

For example, where the level adjusting section is used as the level adjusting section 14b, digital data In1 including an interference wave is supplied to the positive-phase input terminal of the adder 31 and data Lv1 corresponding to the level of the interference wave is supplied to its opposite-phase input terminal. Therefore, digital TV data in which the level of the interference wave corresponding to a video carrier is eliminated is output from the adder 31. On the other hand, where the level adjusting section is used as the level adjusting section 15b, a signal CompLv1 in which a video carrier interference wave is eliminated is supplied to the positive-phase input terminal of the adder 31 and a signal corresponding to the level of the interference wave component corresponding to an audio subcarrier is supplied to its opposite-phase input terminal. Digital TV data in which the level of the interference wave corresponding to the audio subcarrier is eliminated is output from the adder 31. The digital TV data in which the level of the interference wave is eliminated and data having the carrier frequency and extracted by the above-described phase locking section 14a or 15a are supplied to the multiplier 32, and an error signal corresponding to the difference between the levels of the two signals at the carrier frequency is output from the multiplier 32.

The signal component that is output from the multiplier 3 2 as the error signal in this manner is input to the data separating section 33, where a real component and an imaginary component are separated from each other. The imaginary component is supplied to and absorbed by the terminator 34, and only the real component representing the level difference is supplied to the loop filter 35. The loop filter 35 is composed of a time constant circuit for attenuating a higher-frequency component and an integration circuit and has a prescribed response characteristic. An output signal of the loop filter 35 is delayed by a time corresponding to one sample data by the unit delay section 36 so as to proceed the discrete data processing and is given "0" from a data section 38 as an imaginary component by the data shaping section 37 for complex calculation in the multiplier 39.

The multiplier 39 multiplies the error signal component that is supplied in the form of a complex number by an output signal (In2) of the DPLL circuit that is locked to the carrier that is extracted as the interference wave, whereby the level of resulting multiplication data is adjusted so as to become close to the level of the reception interference wave signal. Therefore, by subtracting the output of the multiplier 39 from the level of the interference wave signal being input to the adder 31, feedback control is so made that the real component of the error signal becomes 0. In a steady state, in this level adjusting section, the error signal component representing the level difference converges to 0. As a result, digital TV data CompLv1 or ComLv2 in which the interference wave corresponding to the video carrier or audio subcarrier is eliminated is output from the adder 31.

The level adjusting section is a digital data processing type DPLL circuit that performs known operation of an AM detector using a DPLL circuit. If a video carrier component that is input to the multiplier 32 is written as A·cos (ωt + φ) and a carrier signal component that is phase-locked by the PLL circuit and input to the multiplier 32 is written as K·cos cut, a multiplication output Vo is given by Vo = (A·K/2)cos(2ωt + φ) + (A·K/2)cosφ. Eliminating the AC component (first term) from this equation and assuming φ = 0, we obtain Vo = A·K/2. Since K = 1, a signal that is proportional to the amplitude component A of the video carrier that is the interference wave is output from the multiplier 32. This level adjusting section can also be applied to the TV broadcasting receiver of Fig. 3.

Capable of being configured by digital numerical operations by reading out a program stored in a storage means or the like, the phase locking sections 14a and 15a and the level adjusting sections 14b and 15b according to this embodiment are particularly suitable for digital TV broadcasting receivers. Further, this interference reducing function can be applied to adapters for receiving a digital TV signal that are to be used in viewing a digital TV broadcast using an analog TV receiver in a transition period to digital broadcasts.

## Claims

1. An interference reducing circuit for a television receiver receiving means for receiving a desired digital television broadcasting of OFDM modulation wave of a selected channel, together with an interference analog television broadcasting wave signal, and a signal processing circuit for demodulating an output from said receiving means and for converting said output into digital data;
wherein said interference reducing circuit comprises:
phase locking means (3) for generating a signal component phase-locked to said frequency of the interference wave signal that is mixed in the digital data from said signal processing circuit;
level adjustment means (4) for outputting a replica signal of said interference wave signal by adjusting a level of said signal component from the phase locking means; and
subtracting means (5) for subtracting said replica signal obtained by the level adjusting means from the digital data of said signal processing circuit.

2. The interference reducing circuit according to claim 1, wherein the phase locking means comprises:
a voltage-controlled oscillator for producing a signal having a frequency that is varied by voltage control;
phase comparing means (21) for comparing phases of an output of the voltage-controlled oscillator and the interference wave; and
a feedback circuit for feeding back, as a control voltage for the voltage-controlled oscillator, via a second-order loop filter (24), a phase error signal that is detected by the phase comparing means.

3. The interference reducing circuit according to claim 1 or 2, wherein the level adjusting means (4) comprises a first-order loop filter and adjusts the level of the phase locked signal based on a level of a signal that is produced by the subtracting means (5).

4. The interference reducing circuit according to any one of the preceding claims, wherein the interference wave is an amplitude-modulated or frequency-modulated carrier, and wherein a loop characteristic of the phase locking means (4) is so set as to follow an amplitude modulation component or a frequency modulation component.

5. A TV receiver comprising:
receiving means (6) for receiving a desired digital television broadcasting of OFDM modulation wave of a selected channel together with an interference analog television broadcasting wave signal;
a signal processing circuit (7) for demodulating an output from said receiving means and for converting said output into digital data;
and an interference reducing circuit according to claim 1.

6. The TV receiver according to claim 5, wherein the phase locking means (8) attains locking to an interference wave frequency signal that is video carrier information or audio subcarrier information of said analog TV reception wave that is set in the same channel or in an adjacent channel.

7. The TV receiver according to claim 6, wherein the phase locking means (8) comprises:
a sinusoidal information signal generating section for generating a signal having a phase that is varied in accordance with control information;
phase comparing means for comparing phases of an output of the sinusoidal information signal generating section and the interference wave; and
a feedback circuit for feeding back, as a control voltage for the sinusoidal information signal generating section, via a second-order loop filter, a phase error signal that is detected by the phase comparing means.

8. The TV receiver according to any one of claims 5 to 7, wherein the level adjusting means (9) comprises a first-order loop filter and adjusts the level of the interference wave based on a level of a signal produced by the subtracting means (9).

## Patentansprüche

1. Interferenzreduzierungsschaltung für eine Fernsehempfänger-Empfangseinrichtung zum Empfang von gewünschtem digitalen Fernsehrundfunk einer OFDM-Modulationswelle eines ausgewählten Kanals zusammen mit einem analogen Fernsehrundfunk-Interferenzwellensignal und eine Signalverarbeitungsschaltung zum Demodulieren eines Ausgangssignals aus der Empfangseinrichtung und Umsetzen des Ausgangssignals in digitale Daten,
wobei die Interferenzreduzierungsschaltung aufweist:
eine Phasenverriegelungseinrichtung (3) zur Erzeugung einer Signalkomponente, die bei der Frequenz des in die digitalen Daten aus der Signalverarbeitungsschaltung gemischten Interferenzwellensignals phasenverriegelt ist,
eine Pegeleinstellungseinrichtung (4) zur Ausgabe eines Repliksignals des Interferenzwellensignals durch Einstellen eines Pegels der Signalkomponente aus der Phasenverriegelungseinrichtung, und
eine Subtraktionseinrichtung (5) zum Subtrahieren des von der Pegeleinstellungseinrichtung erhaltenen Repliksignals von den digitalen Daten der Signalverarbeitungsschaltung.

2. Interferenzreduzierungsschaltung nach Anspruch 1, wobei die Phasenverriegelungseinrichtung aufweist:
einen spannungsgesteuerten Oszillator zur Erzeugung eines Signals, das eine Frequenz aufweist, die durch die Spannungssteuerung variiert wird,
eine Phasenvergleichseinrichtung (21) zum Vergleichen von Phasen eines Ausgangssignals des spannungsgesteuerten Oszillators und der Interferenzwelle, und
eine Rückkopplungsschaltung zum Rückkoppeln eines von der Phasenvergleichseinrichtung detektierten Phasenfehlersignals über ein Schleifenfilter (24) zweiter Ordnung als eine Steuerspannung für den spannungsgesteuerten Oszillator.

3. Interferenzreduzierungsschaltung nach Anspruch 1 oder 2, wobei die Pegeleinstellungseinrichtung (4) ein Schleifenfilter erster Ordnung aufweist und den Pegel des phasenverriegelten Signals auf Basis eines Pegels eines von der Subtraktionseinrichtung erzeugten Signals einstellt.

4. Interferenzreduzierungsschaltung nach einem der vorhergehenden Ansprüche, wobei die Interferenzwelle ein amplitudenmodulierter oder frequenzmodulierter Träger ist, und wobei eine Schleifencharakteristik der Phasenverriegelungseinrichtung (4) so eingestellt ist, dass sie einer Amplitudenmodulationskomponente oder einer Frequenzmodulationskomponente folgt.

5. Fernsehempfänger mit:
einer Empfangseinrichtung (6) zum Empfang von gewünschtem digitalen Fernsehrundfunk einer OFDM-Modulationswelle eines ausgewählten Kanals zusammen mit einem analogen Fernsehrundfunk-Interferenzwellensignal,
einer Signalverarbeitungsschaltung (7) zum Demodulieren eines Ausgangssignals aus der Empfangseinrichtung und Umsetzen des Ausgangssignals in digitale Daten, und
einer Interferenzreduzierungsschaltung nach Anspruch 1.

6. Fernsehempfänger nach Anspruch 5, wobei die Phasenverriegelungseinrichtung (8) eine Verriegelung bei einem Interferenzwellenfrequenzsignal erreicht, das eine Videoträgerinformation oder Audiosubträgerinformation der analogen Fernsehempfangswelle ist, die auf den gleichen Kanal oder einen benachbarten Kanal eingestellt ist.

7. Fernsehempfänger nach Anspruch 6, wobei die Phasenverriegelungseinrichtung (8) aufweist:
einen Sinusinformationssignal-Erzeugungsabschnitt zur Erzeugung eines Signals, das eine Phase aufweist, die entsprechend einer Steuerungsinformation variiert wird,
eine Phasenvergleichseinrichtung zum Vergleichen von Phasen eines Ausgangssignals des Sinusinformationssignal-Erzeugungsabschnitts und der Interferenzwelle, und
eine Rückkopplungsschaltung zum Rückkoppeln eines von der Phasenvergleichseinrichtung detektierten Phasenfehlersignals über ein Schleifenfilter zweiter Ordnung als eine Steuerspannung für den Sinusinformationssignal-Erzeugungsabschnitt.

8. Fernsehempfänger nach einem der Ansprüche 5 bis 7, wobei die Pegeleinstellungseinrichtung (9) ein Schleifenfilter erster Ordnung aufweist und den Pegel der Interferenzwelle auf Basis eines Pegels eines von der Subtraktionseinrichtung (9) erzeugten Signals einstellt.

## Revendications

1. Circuit de réduction d'interférence pour un moyen de réception d'un téléviseur pour recevoir un programme de télévision numérique désiré d'une onde de modulation OFDM d'un canal sélectionné, conjointement avec un signal d'onde d'un programme de télévision analogique d'interférence, et un circuit de traitement de signaux pour démoduler une sortie provenant dudit moyen de réception et pour convertir ladite sortie en données numériques ;
dans lequel ledit circuit de réduction d'interférence comprend :
des moyens de verrouillage de phase (3) pour générer une composante de signal verrouillée en phase à ladite fréquence du signal d'onde d'interférence qui est mélangé aux données numériques à partir dudit circuit de traitement de signaux ;
des moyens d'ajustement de niveau (4) pour délivrer un signal réplique dudit signal d'onde d'interférence en ajustant un niveau de ladite composante de signal à partir des moyens de verrouillage de phase ; et
des moyens de soustraction (5) pour soustraire ledit signal réplique obtenu par les moyens d'ajustement de niveau des données numériques dudit circuit de traitement de signal.

2. Circuit de réduction d'interférence selon la revendication 1, dans lequel les moyens de verrouillage de phase comprennent :
un oscillateur commandé en tension pour produire un signal possédant une fréquence qui est modifiée par un réglage de tension ;
des moyens de comparaison de phase (21) pour comparer des phases d'une sortie de l'oscillateur commandé en tension et l'onde d'interférence ; et
un circuit de rétroaction pour réinjecter, comme tension de commande pour l'oscillateur commandé en tension, par l'intermédiaire d'un filtre à boucle de second ordre (24), un signal d'erreur de phase qui est détectée par les moyens de comparaison de phase.

3. Circuit de réduction d'interférence selon la revendication 1 ou 2, dans lequel les moyens d'ajustement de niveau (4) comprennent un filtre à boucle de premier ordre et ajuste le niveau du signal verrouillé en phase en fonction d'un niveau d'un signal qui est produit par les moyens de soustraction (5).

4. Circuit de réduction d'interférence selon l'une quelconque des revendications précédentes, dans lequel l'onde d'interférence est une porteuse modulée en amplitude ou modulée en fréquence, et dans lequel une caractéristique de boucle des moyens de verrouillage de phase (4) est déterminée de manière à suivre une composante de modulation d'amplitude ou une composante de modulation de fréquence.

5. Récepteur TV comprenant :
des moyens de réception (6) pour recevoir un programme de télévision numérique désiré d'onde de modulation OFDM d'un canal sélectionné conjointement avec un signal d'onde de programme de télévision analogique d'interférence ;
un circuit de traitement de signal (7) pour démoduler une sortie provenant desdits moyens de réception et pour convertir ladite sortie en données numériques ;
et un circuit de réduction d'interférence selon la revendication 1.

6. Récepteur TV selon la revendication 5, dans lequel les moyens de verrouillage de phase (8) atteignent le verrouillage à un signal de fréquence d'onde d'interférence qui est une information de porteuse vidéo ou une information de sous-porteuse audio de ladite onde de réception TV analogique qui est déterminée dans le même canal ou dans un canal adjacent.

7. Récepteur TV selon la revendication 6, dans lequel les moyens de verrouillage de phase (8) comprennent :
une section de génération d'un signal d'information sinusoïdal pour générer un signal possédant une phase qui est modifiée conformément à une information de contrôle ;
des moyens de comparaison de phase pour comparer les phases d'une sortie de la section de génération de signal d'information sinusoïdal et l'onde d'interférence ; et
un circuit de rétroaction pour réinjecter, comme tension de commande pour la section de génération de signal d'information sinusoïdal, par l'intermédiaire d'un filtre à boucle de second ordre, un signal d'erreur de phase qui est détecté par les moyens de comparaison de phase.

8. Récepteur TV selon l'une quelconque des revendications 5 à 7, dans lequel les moyens d'ajustement de niveau (9) comprennent un filtre à boucle de premier ordre et ajuste le niveau de l'onde d'interférence en fonction d'un niveau d'un signal produit par les moyens de soustraction (9).
